# EUROPEAN PATENT APPLICATION

(11) **EP 0 718 873 A2**
(43) Date of publication of application: **26.06.1996**
(21) Application number: 95308564.4
(22) Date of filing: 28.11.1995
(51) Int. Cl.: H01L 21/306

(54) **Cleaning process for hydrophobic silicon wafers**

(30) Priority: 21.12.1994 US 361746
(71) Applicant: MEMC Electronic Materials, Inc., St. Peters, Missouri 63376 (US)
(72) Inventor: Pirooz, Saeed, St. Peters, Missouri 63376 (US); Shive, Larry W., St. Peters, Missouri 63376 (US)
(74) Representative: W.P. THOMPSON & CO.

(57) **Abstract**

A process for cleaning particles from a hydrophobic surface of a silicon wafer by chemically oxidizing the hydrophobic surface of the wafer to grow an oxide layer on the surface without nonuniformly etching the surface. The oxide layer renders the surface hydrophilic. The hydrophilic surface is then cleaned with a caustic etching solution to remove particles from the surface.

## Description

### Background of the Invention

The present invention generally relates to wafer cleaning methods. More particularly, the invention relates to a method for treating silicon wafers prior to cleaning them to minimize surface defects formed during the cleaning process.

The preparation of single crystal silicon wafers typically involves the steps of growing a single crystal ingot, slicing the ingot into wafers, lapping, etching and polishing the wafers. Depending upon the required specifications of the electronic device fabricator, the silicon wafers may additionally be subjected to a thermal processing step such as epitaxial deposition to form epitaxial silicon wafers.

Epitaxial wafers are formed by the growth of an epitaxial silicon layer on the surface of a silicon wafer. Silicon is typically deposited from silicon tetrachloride, trichlorosilane, dichlorosilane or monosilane on the wafer surface at a temperature in excess of 950°C via vapor deposition. The epitaxial layer is often grown to provide a high resistivity layer having a resistivity of 0.4 to 50 Ohm-cm on a low resistivity substrate as desired in device fabrication. Processes for preparing epitaxial silicon wafers are well known and include the process described in U.S. Patent No. 3,945,864.

Epitaxial wafers as well as etched or polished wafers generally have a hydrophobic surface which is prone to attract particles and other contaminants. Contaminants from wafer processing are typically removed from the wafers by scrubbing the wafers with a brush or a high pressure fluid jet. These techniques, however, may induce mechanical damage such as when brush patterns are created on the wafer surface. Scrubbing may also contaminate the surface with metals.

Epitaxial wafers and other wafers having hydrophobic surfaces have also been cleaned by immersing the wafers in an SC-1 etchant solution. The ammonium hydroxide component of the etchant solution, however, tends to excessively etch the wafer surface causing roughening and pitting. There is a need for a process wherein wafers having a hydrophobic surface, such as epitaxial wafers, are thoroughly cleaned while minimizing the amount of defects formed on the wafer by the etching process.

### Summary of the Invention

It is a primary object of the present invention to provide a process for cleaning silicon wafers having a hydrophobic surface, such as epitaxial wafers, wherein device yield losses are minimized by protecting the wafer surface from excessive etching. In this connection, a related object of this invention is to provide wafers having minimal particle contamination on their surface.

Other objects and advantages of the invention will be apparent from the following detailed description.

In accordance with the present invention the foregoing objectives are realized by providing a process for cleaning particles from a hydrophobic surface of a silicon wafer. The hydrophobic surface of the wafer is chemically oxidized to grow an oxide layer on the surface without nonuniformly etching the surface. The oxide layer renders the surface hydrophilic. The hydrophilic surface is then cleaned with a caustic etching solution to remove particles from the surface.

The present invention is also directed to a process for passivating the hydrophobic epitaxial surface of a silicon wafer before it is cleaned. The hydrophobic epitaxial surface of the wafer is chemically oxidized to grow an oxide layer on the surface without nonuniformly etching the surface. The oxide layer renders the surface hydrophilic, and has an average surface roughness of less than 0.06 nanometers RMS within a 1 µm by 1 µm area.

Another embodiment of the invention is an epitaxial silicon wafer having an epitaxial silicon surface and a hydrophilic, wet chemical oxide layer contacting the surface, wherein the wafer has an average surface roughness less than 0.06 nanometers RMS within a 1 µm by 1 µm area.

### Brief Description of the Drawings

FIG. 1 illustrates the amount of light point defects of a size greater than 0.12 µm which are detected on the surface of an epitaxial wafer before (-■-) and after (-□-) it is subjected to SC-1 cleaning;
FIG. 2 illustrates the amount of light point defects of a size greater than 0.13 µm which are detected on the surface of an epitaxial wafer after it is oxidized and SC-1 cleaned (-■-); and
FIG. 3 illustrates the amount of light point defects of a size greater than 0.3 µm which are detected on the surface of an epitaxial wafer before treatment (-◆-) and after being oxidized and SC-1 cleaned (-■-).

### Detailed Description of the Preferred Embodiments

In accordance with the present invention, it has been discovered that the epitaxial surface of a silicon wafer, or any other hydrophobic wafer surface, is roughened and pitted during cleaning with a caustic solution unless the composition of the cleaner is carefully controlled. A treatment has been discovered which protects a hydrophobic surface of a silicon wafer from being excessively etched by forming a protective, hydrophilic oxide layer on the surface.

Silicon dioxide is hydrophilic and easily wet by water, whereas a surface of silicon is hydrophobic. For purposes of the present invention, the degree of hydrophilicity or hydrophobicity can be determined by reference to the contact angle of a droplet of water placed on the surface. As used herein, a surface is considered to be hydrophilic if the contact angle is less than 20 degrees. A surface is considered to be hydrophobic if the contact angle of a drop of water placed on the surface is greater than 20 degrees. Silicon wafer having a hydrophobic surface, such as an epitaxial, etched or polished surface, can be protected using this process. A sliced or lapped surface, while being hydrophobic, is not intended to be protected by the process of the present invention until the surfaces are etched or polished to remove most of its surface roughness. Although various hydrophobic wafer surfaces can be protected by the process of the present invention, epitaxial silicon surfaces are particularly described herein.

A wafer is first treated by a wet chemical process in which the wafer surface is contacted with an oxidizing solution which forms a hydrophilic oxide layer on the surface. The oxide layer formed on a silicon surface by a wet chemical process is sometimes referred to as a native oxide layer or a wet chemical oxide layer. The wet chemical oxide layer has a thickness of 0.6 to about 2 nanometers, preferably from about 1 to about 1.5 nanometers. Generally, the contact angle of a water droplet on an oxide layer of preferred thickness is about 3 to about 5 degrees. Thicker oxide layers formed by dry oxidation or thermal oxidation processes, such as gate oxide layers or field oxide layers, are not used in the process of the present invention because the layers are too substantial.

The oxidizing solution used in the wet chemical process is typically a composition which does not etch the wafer surface, such as hydrogen peroxide or ozonated water. However, oxidizing solutions which would uniformly etch the wafer surface can also be used. Although some caustic etchants oxidize a wafer surface, they are not suitable oxidizing solutions for purposes of the invention because they nonuniformly etch the surface.

The preferred oxidizing solution of the present invention is high purity ozonated water, i.e., deionized water containing ozone and having a concentration of no more than about 10 parts per billion (weight/volume) of any metal including, but not limited to, iron, chromium, cobalt, copper, aluminum, germanium, silver, tin, manganese, nickel and titanium. Exposure to the oxidizing solution produces a hydrophilic, wet chemical oxide layer on the surface of the epitaxial silicon layer to passivate (i.e., protect) the surface of the epitaxial layer from excessive etching without adding metals or otherwise contaminating the surface. The silicon oxide layer has a concentration of no more than 1 x 10¹⁰ atoms/cm² of any metal as listed above.

Silicon oxide layers of this thickness and purity may be produced by immersing the wafers in a bath of 3 to 18 mega-Ohm deionized water containing about 0.05 parts per million (ppm) to 50 ppm of ozone, at a temperature of about 0°C to about 60°C for a period of about 2 to about 60 minutes. The wafers can be immersed in the ozonated water for a longer period of time although little if any additional oxide will form on the surfaces when exposed for more than one hour. Immersion in a bath of about 10 to about 18 mega-Ohm deionized water containing about 10 to about 15 ppm ozone at room temperature for about 2 to about 20 minutes is preferred.

If the epitaxial wafers are not subjected to cleaning immediately after formation of the oxide layer, the wafers are rinsed to remove bubbles and loosely adhered particles from the wafer surfaces prior to being dried. The treated wafers are rinsed for a period of about 2 to about 60 minutes, typically about 5 to about 45 minutes, in deionized water having a resistivity of about 3 to about 18 mega-Ohms, preferably greater than about 17 mega-Ohms. The rinse water is recirculated at a rate of about 3 to about 8 gallons per minute (about 11.36 to about 30.28 liters per minute) to ensure that the surface reaction is quenched and surface particles are removed. If the recirculation rate is too high, the turbulence of the water can cause particles to redeposit on the surfaces of the wafers.

The treated epitaxial silicon wafers may be cleaned by being immersed in any of a number of cleaning solutions which are well-known to those of ordinary skill. They include piranha mixtures (mixtures of sulfuric acid and hydrogen peroxide) and SC-1 mixtures. An SC-1 solution removes organic contaminants and particles by both the solvating action of ammonium hydroxide and the powerful oxidizing action of hydrogen peroxide. As the ammonium hydroxide etches the oxide surface and removes a portion of the oxide, the hydrogen peroxide deposits additional oxide on the hydrophilic oxide surface. The ammonium hydroxide also serves to complex metals such as copper, gold, nickel, cobalt, zinc and calcium. A hydrophilic oxide layer having a thickness and metals concentration as described above remains on the wafer surface after SC-1 cleaning.

The SC-1 cleaning solution contains between about 1000:1:1 to 1:1:1 parts by volume H₂O:H₂O₂: NH₄OH (supplied as 30-35% H₂O₂ in water and 28-30 wt% NH₄OH in water) ; that is, the SC-1 cleaning solution contains H₂O, H₂O₂ and NH₄OH and the ratio of H₂O to H₂O₂ (supplied as 30-35 wt% H₂O₂ in water) is between about 1000:1 and 1:1, and the ratio of H₂O to H₂O₂ is independent of the ratio of H₂O to NH₄OH. Preferably, the SC-1 cleaning solution contains about 100:1:1 to about 5:1:1 parts by volume H₂O:H₂O₂:NH₄OH, and has a temperature of about 30°C to about 80°C, preferably about 60°C to 80°C. Because the epitaxial wafers are fairly clean and require less etching to affect particle removal than typical silicon wafers, a more preferred SC-1 solution contains about 50:10:1 to about 5:1:1 parts by volume H₂O:H₂O₂:NH₄OH.

The wafers are preferably cleaned in an SC-1 solution for about 5 to about 30 minutes, preferably from about 10 to about 20 minutes. If the wafers are immersed in the cleaning solution for a longer time, excessive etching, pitting and roughening can occur. The cleaner is recirculated at a rate of about 2 to about 10 gallons per minute (about 7.57 to about 37.85 liters per minute), preferably about 3 to about 6 gallons per minute (about 11.36 to about 22.71 liters per minute). If the recirculation rate is higher, excessive etching, pitting and roughening may occur. However, if the rate is too low, the after surface will not be properly etched.

After cleaning, the wafers are immersed in a rinse bath to quench the reaction and remove the SC-1 cleaner from the wafer surfaces. The wafers are rinsed for a period of about 2 to about 60 minutes, typically from about 5 to about 45 minutes, in deionized water having a resistivity of about 3 to about 18 mega-Ohms, preferably greater than about 17 mega-Ohms. The rinse water is recirculated at a rate of about 3 to about 8 gallons per minute (about 11.36 to about 30.29 liters per minute) to ensure that the surface reaction is quenched and surface particles are removed.

The cleaned and rinsed wafers can then be dried or processed further to reduce metallic contamination. If a minimum metals concentration on the wafer surface is desired, the metals can be removed by contacting the silicon wafers with an HF solution or an SC-2 solution. A typical aqueous HF solution contains about 1:1 to 1:10,000 parts by volume HF:H₂O (supplied as 49 wt% HF in water). To enhance metals removal, the solution may additionally contain HCl (1000:1 to 1:1000 parts by volume HF:HCl), hydrogen peroxide (1:1 to 1:1000 parts by volume HF to H₂O₂), isopropyl alcohol (10,000:1 to 1:10 parts by volume HF:IPA) or ozone (about 0.05 to about 50 ppm). A typical SC-2 bath may contain 1:1:5 to 1:1:1000 parts by volume of HCl:H₂O₂:H₂O. The temperature of the HF and SC-2 solutions may be about 10°C to about 90°C, and the silicon wafers are immersed in a flowing bath of this solution for a period of at least about 0.1 minutes. These solutions effectively remove alkali and transition metals, and prevent redeposition from the solution by forming soluble metal complexes.

After metals removal, the silicon wafers are rinsed for a period of at least about 0.1 minutes and typically about 2 to about 10 minutes in deionized water. The water preferably has a resistivity of about 3 to about 18 mega-Ohms, preferably greater than about 17 mega-Ohms.

Once the wafers have been cleaned and treated to reduce metallic contamination if needed, the process is completed by drying the wafers. The wafers may be dried using any method which does not recontaminate the wafers with metals or particles. Such methods include conventional spin drying and isopropyl alcohol vapor drying techniques which are well known in the art.

Ideally, the cleaning process is carried out in a conventional wet bench cleaning apparatus which comprises a series of tanks containing approximately 1 to 100 liters of flowing solution. In addition, the process is preferably controlled such that up to 100 wafers are automatically transported to and immersed in the oxidizing solution, cleaning bath, etc. All wetted parts are constructed of quartz, polyvinylchloride ("PVC"), polyvinylidine-difluoride ("PVDF"), polypropylene or teflon.

In order to increase throughput, the wafers can be cleaned in a series of two or more SC-1 baths by immersing the wafers in a first SC-1 bath for a portion of the cleaning period, rinsing the wafers, immersing the wafers in a second SC-1 bath for the remainder of the cleaning period, and rinsing the wafers.

The oxide layer provides the epitaxial wafers with a smoother, more uniform surface after the wafers are cleaned. The surface roughness of an epitaxial wafer of the invention is significantly lower than that of an untreated epitaxial wafer or an epitaxial wafer which is not oxidized prior to SC-1 cleaning. The wafers of the invention have an average surface roughness of less than 0.06 nanometers RMS (root mean squared) within a 1 µm by 1 µm area, preferably determined using an instrument sold under the trademark NANOSCOPE III by Digital Instruments, Inc., operated in the tapping mode. If the epitaxial wafer surface is substantially free of particles before it is chemically oxidized, the surface may not require subsequent cleaning in an SC-1 solution. The wafer can then be dried or further processed to remove metal contaminants, if desired.

The following example is presented to describe preferred embodiments and utilities of the present invention and is not meant to limit the present invention unless otherwise stated in the claims appended hereto.

### Example

Smooth silicon wafers having an epitaxial layer grown to a thickness of about 4.5 µm and a resistivity target of 2.5 Ohm-cm were inspected to determine the particle defects on their surface as measured with a Tencor 6200 automatic wafer inspection system. A cleaning process was then carried out on sets of the wafers using a conventional wet bench cleaning apparatus. The cleaning sequence for the wafers was as follows:
1. immersion in recirculating ozonated deionized water
   bath (14 ppm O₃; metals each less than 0.01 ppb) at room temperature for 5 minutes;
2. 10 minutes in an SC-1 bath (1:10:50 NH₄OH:H₂O₂:H₂O) with megasonics at 70°C;
3. water rinse for 5 minutes;
4. 10 minutes in an SC-1 bath (1:10:50 NH₄OH:H₂O₂:H₂O) with megasonics at 70°C;
5. water rinse for 5 minutes;
6. 5 minutes in a metals removal solution (1:100 HCl:H₂O);
7. water rinse for 5 minutes; and
8. IPA (isopropyl alcohol) dried for 10 minutes.

In order to determine the passivating effect of an oxide layer, one set of epitaxial wafers (set A) was subjected to steps 2-8 above, while another set of wafers (set B) was oxidized and cleaned according to steps 1-8 above. After cleaning, the wafers were analyzed for surface particle contamination by a Tencor 6200.

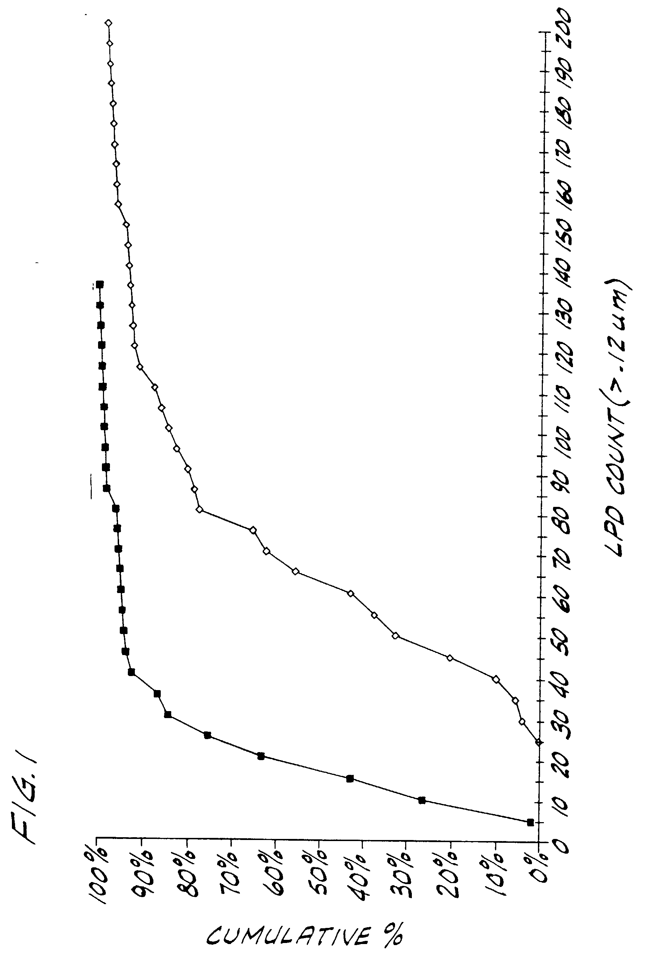

Figure 1 illustrates the amount of light point defects (LPD) per wafer of a size greater than 0.12 µm before the epitaxial wafers without a protective oxide layer (set A) were cleaned (-■-) and after cleaning (-□-) The mean for the wafers prior to cleaning was about 18 LPD as compared to about 64 LPD after the wafers were cleaned. The LPD count of epitaxial wafers without a protective oxide layer increased by about 250% after cleaning, indicating that the surface became roughened and pitted during the etching process.

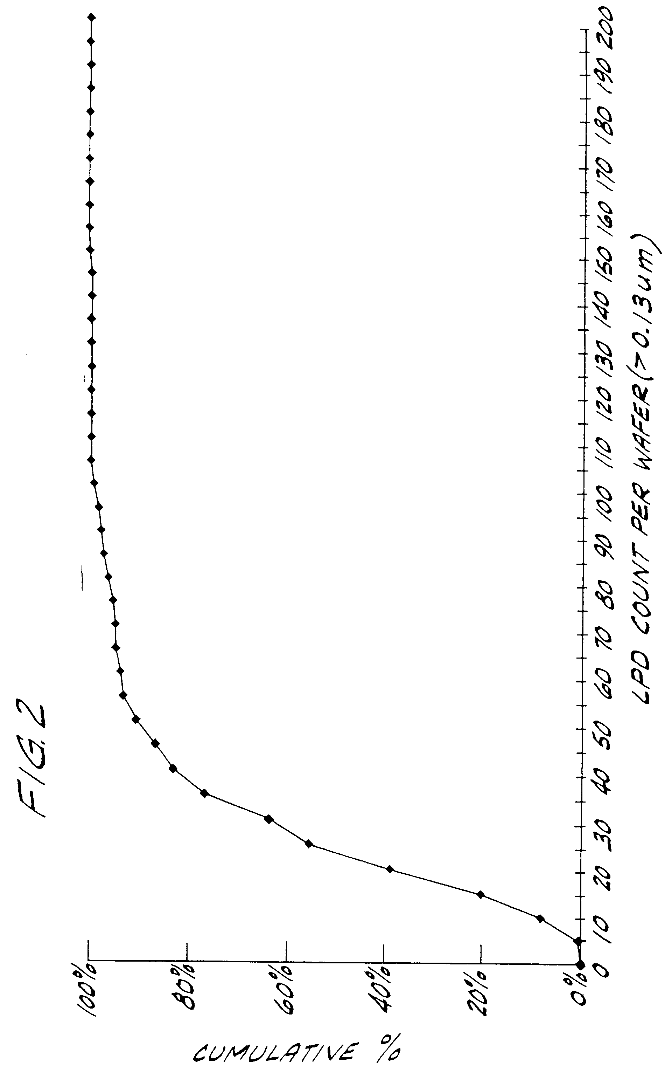

Figure 2 shows the amount of LPD per wafer of a size greater than 0.13 µm after the wafers of set B were oxidized and cleaned. The mean of the oxidized and cleaned wafers was only about 25 LPD. The protective oxide layer significantly reduced damage to the wafer surface caused by the etching process.

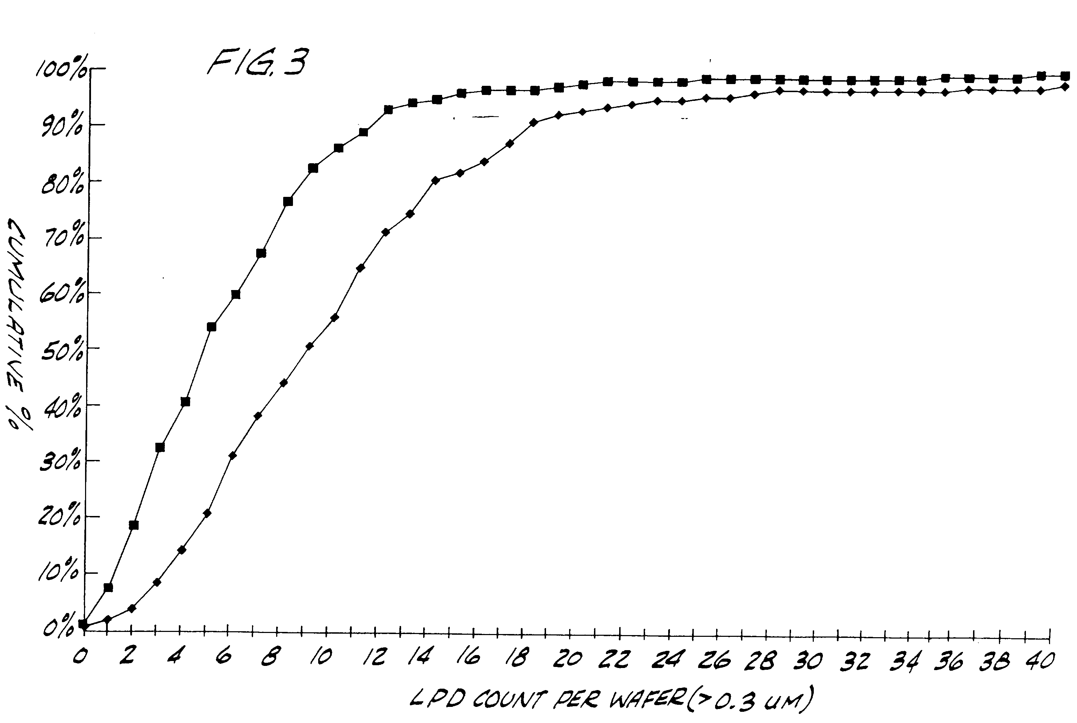

Another experiment was conducted to determine whether addition of a protective oxide layer improves the surface roughness of an epitaxial wafer. Another set of epitaxial wafers were analyzed for particle contamination before oxidation and cleaning. After being subjected to an oxidation and cleaning treatment as described in steps 1-8 above, the wafers were analyzed for particle contamination. The analysis revealed average particle counts of 29.0 LPD per wafer of a size of at least 0.13 µm prior to treatment as compared to 17.0 LPD per wafer after oxidation and cleaning. The average particle counts of a size of at least 0.30 µm were 5.2 prior to oxidation and cleaning and 3.8 after treatment (see Figure 3). The reduced particle contamination of the wafers after oxidation and cleaning significantly improved the yield. The yield for the untreated epitaxial wafers was only 15% as compared to an 85% yield after the wafers were oxidized and cleaned.

While the invention is susceptible to various modifications and alternative forms, specific embodiments thereof have been shown by way of example and were herein described in detail. It should be understood, however, that it is not intended to limit the invention to the particular form disclosed, but on the contrary, the intention is to cover all modifications, equivalents and alternatives falling within the spirit and scope of the invention as defined by the appended claims.

## Claims

1. A process for cleaning particles from a hydrophobic surface of a silicon wafer comprising:
chemically oxidizing the hydrophobic surface of the wafer to grow an oxide layer on the surface without nonuniformly etching the surface, wherein the oxide layer renders the surface hydrophilic; and
cleaning the hydrophilic surface with a caustic etching solution to remove particles from the surface.

2. A process according to claim 1, wherein the hydrophilic surface has a concentration of less than 1 x 10¹⁰ atoms/cm² of any metal.

3. A process according to claim 1 or claim 2, wherein the hydrophobic surface of the wafer is oxidized by ozonated water.

4. A process according to claim 1 or claim 2, wherein the hydrophobic surface of the wafer is oxidized by hydrogen peroxide.

5. A process according to any one of claims 1 to 4, wherein the hydrophobic surface is an epitaxial, etched or polished surface.

6. A process according to any one of claims 1 to 5, wherein the caustic etching solution contains a hydroxide and a peroxide.

7. A process according to any one of claims 1 to 6, wherein the caustic etching solution contains hydrogen peroxide and ammonium hydroxide.

8. A process according to any one of claims 1 to 7, wherein the oxide layer comprises silicon dioxide and has a thickness of at least 0.6 nanometers.

9. A process according to any one of claims 1 to 8, wherein the oxide layer is from about 1 to about 1.5 nanometers thick.

10. A process according to any one of claims 1 to 9, wherein the wafer is rinsed with water after it is oxidized and after it is exposed to the caustic etching solution.

11. A process for passivating a hydrophobic epitaxial surface of a silicon wafer before the wafer is cleaned comprising chemically oxidizing the hydrophobic epitaxial surface of the wafer to grow an oxide layer on the surface without nonuniformly etching the surface, wherein the oxide layer renders the surface hydrophilic, and the oxide layer has an average surface roughness less than 0.6 nanometers RMS within a 1 µm by 1 µm area.

12. A process according to claim 11, wherein the hydrophilic epitaxial surface has a concentration of less than 1 x 10¹⁰ atoms/cm² of any metal.

13. A process according to claim 11 or claim 12, wherein the hydrophobic epitaxial surface of the wafer is oxidized by ozonated water.

14. A process according to claim claim 11 or claim 12, wherein the hydrophobic epitaxial surface of the wafer is oxidized by hydrogen peroxide.

15. An epitaxial silicon wafer having an epitaxial silicon surface and a hydrophilic, wet chemical oxide layer contacting the surface, wherein the oxide layer has an average surface roughness less than 0.06 nanometers RMS within a 1 µm by 1 µm area.

16. A process according to claim 15, wherein the oxide layer has a concentration of less than 1 x 10¹⁰ atoms/cm² of any metal.

17. A process according to claim 15 or claim 16, wherein the oxide layer comprises silicon dioxide.

18. A process according to any one of claims 15 to 17, wherein the oxide layer has a thickness of at least 0.6 nanometers.

19. A process according to any one of claims 15 to 18, wherein the oxide layer is from 0.6 nanometers to about 2 nanometers thick.

20. A process according to any one of claims 15 to 19, wherein the oxide layer is from about 1 nanometers to about 1.5 nanometers thick.
